# Europäisches Patentamt

# European Patent Office

# Office européen des brevets

(19)

(11) Veröffentlichungsnummer: **0 205 199**
**A1**

(12) ## EUROPÄISCHE PATENTANMELDUNG

(21) Anmeldenummer: **86200856.2**

(22) Anmeldetag: **20.05.86**

(51) Int. Cl.⁴: **G 01 N 24/08**

(30) Priorität: **22.05.85 NL 8501459**

(43) Veröffentlichungstag der Anmeldung:
**17.12.86 Patentblatt 86/51**

(84) Benannte Vertragsstaaten:
**DE FR GB IT**

(71) Anmelder: **N.V. Philips' Gloeilampenfabrieken**
**Groenewoudseweg 1**
**NL-5621 BA Eindhoven(NL)**

(72) Erfinder: **den Boef, Johannes H.**
**i/A INT. OCTROOIBUREAU B.V. Prof. Holstlaan 6**
**NL-5656 AA Eindhoven(NL)**

(74) Vertreter: **Faessen, Louis Marie et al,**
**INTERNATIONAAL OCTROOIBUREAU B.V. 6 Prof.**
**Holstlaan**
**NL-5656 AA Eindhoven(NL)**

(54) **Verfahren zur Verringerung von Artefakten bei der Bestimmung von Bildern mit hilfe von Kernspintomographie.**

(57) In Kernspinresonanzbildern, die mit Hilfe der Kernspintomographie bestimmt sind, treten störende Artefakte auf, die durch kohärente Störsignale verursacht werden (beispielsweise Verlagerungssignale, nicht ideale 180°-Umkehrimpulse). Erfindungsgemäss wird zwischen den Resonanzsignalen ein zusätzlicher Phasenunterschied $\Delta\varphi = \pi$ bei geradzahligen Zeilen, $\Delta\varphi = \pi$. $(m-1)/m$ rad/sec/bei m ungeradzahligen Zeilen erzeugt und die von den Resonanzsignalen genommenen Signalproben werden in die benachbarten Zeilen einer Bildfrequenzmatrix eingeschrieben. Beträgt die zusätzliche Phasendrehung $\pi$ rad/sec, so werden die Werte in jeder zweiten Zeile der Matrix invertiert, wodurch die Beiträge der kohärenten Signale in der Matrix für die zusätzliche Phasendrehung korrigiert werden und die Werte jeder zweiten Zeile von Störsignalen in der Richtung der Spalten bei jeder Zeile das Vorzeichen wechseln. Bei der Fouriertransformation der Spalten werden daher die von den Störsignalen verursachten Artefakte zum Rand des Bildes hin verschoben.

FIG.4

EP 0 205 199 A1

"Verfahren zur Verringerung von Artefakten bei der Bestimmung von Bildern mit Hilfe von Kernspintomographie".

Die Erfindung betrifft ein Verfahren zur Bestimmung einer Kernmagnetsierungsverteilung in einem Teil eines Körpers, bei dem ein statisches, einheitliches Magnetfeld erzeugt wird, in dem sich ein Teil des Körpers befindet, und

a) ein hochfrequenter elektromagnetischer Impuls zum Erhalten einer Präzessionsbewegung der Magnetisierung von Kernen im Körper und dadurch ein Resonanzsignal erzeugt wird,

b) wonach in einer Vorbereitungszeit zumindest ein Gradientenmagnetfeld angelegt wird,

c) wonach in eine Messzeit eine Anzahl von Signalproben des Resonanzsignals genommen wird,

d) wonach jeweils nach einer Wartezeit ein Messzyklus mit den Schritten a), b) und c), bei dem das Integral der Stärke zumindest eines Gradientenfeldes über die Vorbereitungszeit jedesmal einen verschiedenen Wert hat, zum Erhalten einer Gruppe von Signalproben in einer aus (n') Zeilen und (n) Spalten bestehenden Matrix einige Male wiederholt wird, aus der nach der Fouriertransformation derselben ein Bild der Verteilung der induzierten Kernmagnetisierung bestimmt wird.

Die Erfindung bezieht sich weiter auf eine Anordnung zur Bestimmung der Kernmagnetisierungsverteilung in einem Teil des Körpers, und diese Anordnung enthält

a) Mittel zum Erzeugen eines statischen einheitlichen Magnetfelds,

b) Mittel zum Erzeugen einer hochfrequenten elektromagnetischen Strahlung,

c) Mittel zum Erzeugen zumindest eines Gradientenmagnetfelds,

d) Abtastmittel zum Abtasten eines mit den unter a) und b) genannten Mitteln erzeugten Resonanzsignals in einer Messzeit nach der Konditionierung des Resonanzsignals während einer Vorbereitungszeit,

e) Verarbeitungsmittel zum Verarbeiten der von den Abtastmitteln gelieferten Signale, und

f) Steuermittel zum Steuern zumindest der unter b) bis
einschliesslich e) genannten Mittel zum Erzeugen, Konditionieren, Abtasten und Verarbeiten einer Anzahl von Resonanzsignalen, wobei jedes Resonanzsignal stets in einer
Vorbereitungszeit unterschiedlich konditioniert wird.

Unter dem Begriff Kernmagnetisierungsverteilung
sei sowohl die Kernspindichteverteilung, eine Flussgeschwindigkeitsverteilung, eine Relaxationszeit $T_1$, $T_2$-Verteilung
sowie eine Kernspinresonanzfrequenzspektrumverteilung
(ortabhängige Kernspinspektroskopie), usw. verstanden.

Ein derartiges Verfahren (auch mit Zeugmatographie
bezeichnet) und eine derartige Anordnung sind aus der deutschen Patentanmeldung DE-OS 26 11 497 bekannt. Bei einem
derartigen Verfahren wird ein zu untersuchender Körper
einem starken, statischen einheitlichen Magnetfeld Bo unterworfen, dessen Feldrichtung beispielsweise mit der z-Achse
eines Karthesis-(x, y, z)-Koordinatensystems zusammenfällt.
Mit dem statischen Magnetfeld Bo wird eine geringe Polarisierung der im Körper vorhandenen Kernspins erhalten und
wird die Möglichkeit geschaffen, Kernspins eine Präzessionsbewegung um die Richtung des Magnetfelds Bo ausführen
zu lassen. Nach dem Anlegen des Magnetfelds Bo wird ein
vorzugsweise $90^o$-Impuls einer elektromagnetischen Hochfrequenzstrahlung erzeugt (mit einer Winkelfrequenz $\omega = \gamma \cdot Bo$,
worin $\gamma$ das gyromagnetische Verhältnis und Bo die Stärke
des Magnetfelds darstellen), die die Magnetisierungsrichtung der im Körper vorhandenen Kerne über einen Winkel $(90^o)$
dreht. Nach dem Ablauf des $90^o$-Impulses präzedieren die
Kernspins um die Feldrichtung des Magnetfeldes Bo und erzeugen ein Resonanzsignal (Kerninduktionssignal). Mit den
Gradientenmagnetfeldern $G_x$, $G_y$, $G_z$, deren Feldrichtung mit
der des Magnetfelds Bo zusammenfällt, ist es möglich,
ein Gesamtmagnetfeld $B = Bo + G_x \cdot x + G_y \cdot y + G_z \cdot z$ zu
erzeugen, dessen Stärke ortabhängig ist, weil die Stärke
der Gradientenmagnetfelder $G_x$, $G_y$, $G_z$ einen Gradienten in

PHN 11.386    3    0205199

der x-, y- bzw. z-Richtung hat.

Nach dem $90^o$-Impuls wird ein Feld $G_x$ eine Zeit $t_x$ angelegt und anschliessend ein Feld $G_y$ eine Zeit $t_y$, wodurch die Präzessionsbewegung der angeregten Kernspins ortsabhängig beeinflusst wird. Nach dieser Vorbereitungs phase (also nach $t_x + t_y$) wird ein Feld $G_z$ angelegt und wird das Kerninduktionssignal (faktisch die Summe aller Magnetisierungen der Kerne) eine Zeit $t_z$ an $N_z$ Messzeitpunkten abgetastet. Das oben beschriebene Messverfahren wird dann anschliessend $1 \times m$ -mal wiederholt, wobei für $t_x$ und/oder $t_y$ immer verschiedene Werte genommen werden. Hierdurch werden ($N_z \times m \times 1$) Signalproben erhalten, die die Information über die Magnetisierungsverteilung in einem Teil des Körpers im x-y-z-Raum enthalten. Die $1 \times m$ gemessenen $N_z$-Signalproben werden jeweils in einen Speicher eingeschrieben (an $N_z \times m \times 1$ Speicherstellen), wonach durch eine dreidimensionale Fouriertransformation der Signalproben der Kerninduktionssignale ein Bild der Kernmagnetisierungsverteilung erhalten wird. Selbstverständlich ist es auch möglich, mit Hilfe selektiver Anregung nur das Kerninduktionssignal der Kernspins in einer (beliebig in der Orientierung zu wählenden) zweidimensionalen Fläche zu erzeugen, so dass dabei beispielsweise nur m-mal ein Kerninduktionssignal erzeugt zu werden braucht, um über eine zweidimensionale Fouriertransformation ein Bild der Magnetisierungsverteilung in $m \times N_z$ Punkten in der gewählten Fläche zu erhalten.

Mit dem oben beschriebenen Verfahren wird eine Kernspindichteverteilung in einer zweidimensionalen Ebene oder in einem dreidimensionalen Volumen bestimmt. Mit einem gleichartigen Verfahren ist es möglich, beispielsweise je Bildelement in einer Fläche oder in einem Volumen ein Frequenzspektrum zu bestimmen, das den metabolischen (chemischen) Zustand der Materie in diesem Bildelement darstellt. Dazu muss beispielsweise in der Messzeit kein Gradientenfeld und in der Vorbereitungszeit müssen 1, 2 oder 3 Gradientenfelder angesetzt werden. Mit einem derartigen Verfahren wird eine zwei-, drei- oder vierdimensionale Matrix mit Signalproben gefüllt, die nach einer zwei-, drei- oder vierdimensionalen Fouriertransormation in ortsabhängige Frequenzspektren umgewandelt wird, wobei die Ortsabhängigkeit eine, zwei oder drei Dimensionen hat (beispielsweise x oder x, y oder x, y, z).

Die Bilder der Kernmagnetisierungsverteilung, die mittels der in den obigen Absätzen beschriebenen 2-, 3- oder mehrdimensionalen Kernspin-Zeugmatographie erhalten sind, enthalten leider Artefakte, die die im Kernspinresonanzbild vorhandene Information stören oder sogar (teilweise) beseitigen. Die Kernspinresonanzbilder werden durch Anwendung einer (zweidimensionalen, dreidimensionalen usw.) Fouriertransformation auf die demodulierten Resonanzsignale erhalten, die aus Niederfrequenzsignalen mit einer Frequenz f bestehen, die in einem Gebiet $0 < |f| < f_{max}$ liegen. Die Bildartefakte sind häufig unerwünschten Signalen in diesem Frequenzbereich zuzuschreiben. Ein erstes Artefakt tritt als einen Bildpunkt in einem Zentrum des Bildes mit einer abweichenden Intensität hervor und entsteht durch Verlagerungsspannungen u.dgl. Ein weiteres Artefakt ist ein zweites Bild, das auf dem ersten Bild liegt. Dergleiche Artefakt treten bei der Verwendung ungenauer $180^\circ$-Impulse auf. die bei der Durchführung sog. Spinechotechniken verwendet werden. Die Urheber der Artefakte werden im weiteren mit kohärenten Störsignalen bezeichnet. Durch diese kohärenten Störsignale liegen faktisch zwei Informationsarten durcheinander, was äusserst störend und unerwünscht ist. Eine Lösung zum Beseitigen von Artefakten ist die Doppelmessung jeder Signalprobe in der Matrix, wobei die Anregung des Resonanzsignals bei der ersten Messung der bei der zweiten Messung entgegengesetzt ist. Die Addierung der zwei Signalproben gleicht die aufgetretenen Fehler aus und reduziert die Artefakte. Jedoch fragt eine derartige Lösung eine doppelt so lange Messzeit, was unerwünscht ist.

Der Erfindung liegt die Aufgabe zugrunde, ein Verfahren und eine Anordnung zu schaffen, mit denen Kernspinresonanzbilder hergestellt werden, die (auch bei der Verwendung von Spinecho-Kernspinresonanztechniken) nicht durch Artefakte gestört werden, bei denen die zur Signalprobenahme erforderliche Zeit nicht länger als beim bekannten Verfahren und bei den bekannten Anordnungen ist, bei denen die Artefakte nicht vermieden werden.

Diese Aufgabe wird mit einem Verfahren nach der Erfindung dadurch gelöst, dass während mehrerer Messzyklen eine Amplitudenmodulation des statischen, einheitlichen Magnetfelds derart erfolgt, dass zwischen den Resonanzsignalen, die zu den verschiedenen hinsichtlich des Wertes des Integrals der Stärke des Gradientenfeldes über die Vorbereitungszeit aufeinanderfolgenden Zeilen in der Matrix gehören, immer der gleiche Phasenunterschied $(\Delta \psi)$ bewirkt wird, und dass für Fouriertransformation von in Spalten der Matrix vorhandenen Werten die bewirkten zusätzlichen Phasenunterschiede beseitigt werden.

Ein Ausführungsbeispiel eines erfindungsgemässen Verfahrens ist dadurch gekennzeichnet, dass die Anzahl der Zeilen der Matrix geradzahlig ist, dass der zusätzliche Phasenunterschied $\Delta \psi$ gleich $\pi$ rad/s. ist, und dass für Fouriertransformation von in Spalten der Matrix vorhandenen Werten entweder in den ungeradzahligen Zeilen oder in den geradzahligen Zeilen vorhandene Werte invertiert werden, um den zusätzlichen Phasenunterschied zu beseitigen.

Mit dem beschriebenen Verfahren wird folgendes erreicht: die in den Messzyklen gewonnen Signalproben werden in einer Matrix gespeichert, wobei die Zeilenposition (die Zeilenindexnummer) der in einer Zeile zu speichernden Anzahl von (n) Signalproben durch die Reihenfolge von Werten des Integrals der Stärke des Gradientenmagnetfelds über die Vorbereitungszeit in den verschiedenen Messzyklen bestimmt wird. Ein kohärentes Störsignal, beispielsweise ein Verlagerungssignal, das die zum Detektieren und Abtasten des Resonanzsignals erforderlichen elektronischen Schaltungen erzeugen, tritt in jeder Signalprobe auf gleiche Weise auf. Werden nunmehr jedoch Signalproben eines Resonanzsignals von jeder zweiten Zeile genommen, wobei dieses Resonanzsignal in Gegenphase gebracht ist, kehrt der Einfluss der kohärenten Störsignale nach der Inversion jeder zweiten Zeile stets von der einen Zeile zur folgenden das Vorzeichen um. Die Folge davon ist, dass nach der Fouriertransformation über die Spalten der Matrix der Einfluss nur in den Randelementen der Spalten einer Bildmatrix auftritt, weil die stets zeilenweise das Vorzeichen wechselnden Störsignale die höchste in der Matrix auftretende Frequenz enthält. Durch die Anwendung der Gegenphasierung der Resonanzsignale ist also der Beitrag der Verlagerungsspannung im zentralen Bildpunkt (Frequenz 0) durch die Fouriertransformation zum Rand des Bildes hin verschoben, was viel weniger störend ist. Zur obigen Beschreibung sei noch bemerkt, dass die wechselnden kohärenten Störsignale durch die Fouriertransformation in eine an sich bekannte Punktstreufunktion (point spread function) umgewandelt werden, deren Position des Maximums durch die Anzahl von Werten in den Spalten bestimmt ist. Ist die Anzahl eine gerade Anzahl, liegt das Maximum der Punktstreufunktion an einer Seite der Spalte im äusseren Spaltenelement. In allen übrigen Spaltenelementen ist der Wert der Punktstreufunktion gleich null. Hat eine Spalte eine ungerade Anzahl von Werten, so erhalten nach der Fouriertransformation die an beiden Seiten der Spalte liegenden äusseren Elemente einen höchsten Beitrag der Punktstreufunktion. Die angrenzenden Elemente erhalten einen immer weiter geringer werdenden Beitrag bei sich vergrösserndem Abstand zum äusseren Element (bis zum mittleren Element der Spalte).

Bei der Anwendung der Spinecho-Kernspinresonanztechnik werden 180°-Anregungsimpulse zum Erzeugen eines Spinechoresonanzsignals benutzt. Mit dem 180°-Impuls werden Spins über 180° in der Phase gedreht. Werden jedoch nicht ideale 180°-Impulse verwendet, werden Spins nicht ideal angeregt und nehmen eine andere Phase an als verlangt. Auch werden Spins in die verlangte Phase gebracht, die nicht dahin gehören, da der 180°-Anregungsimpuls mit dem 90°-Anregungsimpuls kohärent erfolgt. Die unerwünschten angeregten Kernspins liefern einen Signalbeitrag, der dem gewünschten Resonanzsignal überlagert ist, was nach der Fouriertransformation zu unerwünschter Bildinformation führt, die in einem gewonnen Bild mit der gewünschten Bildinformation verschachtelt ist.

Indem jetzt erfindungsgemäss die angegebenen Phasenunterschiede ($\Delta \psi$) erzeugt und für Fouriertransformation beseitigt werden, wird das von den unerwünschten angeregten Kernspins erzeugte kohärente Störsignal nach der Inversion der Signalproben in jeder zweiten Zeile der Matrixs durch Fouriertransformation über die Spalten nach dem Rand des gewonnenen Bildes verschoben. Es sei dazu bemerkt, dass zum wirksamsten Verringern von Bildartefakten durch die nicht idealen $180^{o}$-Impulse das Vorbereitungsgradientenmagnetfeld vorzugsweise im Zeitraum zwischen dem $90^{o}$-Anregungsimpuls und dem $180^{o}$-Impuls erzeugt wird.

Bei der Durchführung dreidimensionaler Kernspintomographie ist die Erfindung ebenfalls anwendbar. Ein Ausführungsbeispiel eines Verfahrens zur Bestimmung einer Kernmagnetisierungsverteilung in einem dreidimensionalen Teil eines Körpers, wobei ein statisches, einheitliches Magnetfeld erzeugt wird, in dem sich der Körper befindet, und

a) ein hochfrequenter elektromagnetischer Impuls zum Bewirken einer Präzessionsbewegung der Magnetisierung von Kernen im Körper erzeugt wird, wobei ein Resonanzsignal erzeugt wird,

b) wonach in einer Vorbereitungszeit zumindest ein erstes und ein zweites Vorbereitungsgradientenmagnetfeld angelegt wird, deren Feldrichtungen senkrecht zueinander verlaufen,

c) wonach in einer Messzeit eine Anzahl von Abtastsignalen vom Resonanzsignal genommen wird,

d) wonach jeweils nach einer Wartezeit ein Messzyklus mit den Schritten a), b) und c) einige Male wiederholt wird, wobei ein erstes Integral der Stärke des ersten Gradientenfeldes über die Vorbereitungszeit eine erste Anzahl verschiedener Werte hat und ein zweites Integral der Stärke des zweiten Gradientenfeldes über die Vorbereitungszeit eine zweite Anzahl verschiedener Werte zum Erhalten einer Gruppe von Signalproben in einer aus Reihen, Zeilen und Spalten bestehenden dreidimensionalen Matrix, von der eine Fläche Zeilen und Spalten enthält, wobei je Messzyklus zumindest eine Zeile einer Fläche gefüllt und aus dieser Matrix nach der Fouriertransformation derselben ein Bild der Verteilung der induzierten Kernmagnetisierung in einem dreidimensionalen Teil eines Körpers bestimmt wird, ist dadurch gekennzeichnet, dass in mehreren Messzyklen eine Amplitudenmodulation des statischen, einheitlichen Magnetfelds derart erfolgt, dass zwischen den Resonanzsignalen, die zu den verschiedenen hinsichtlich des Wertes des Integrals der Stärke des ersten Gradientenfeldes über die Vorbereitungszeit aufeinanderfolgenden Flächen in der Matrix gehören und zwischen den Resonanzsignalen, die zu den verschiedenen, hinsichtlich des Wertes des Integrals der Stärke des zweiten Gradientenfeldes über die Vorbereitungszeit aufeinanderfolgenden Zeilen in einer Fläche der Matrix gehören, stets ein erster und ein zweiter zusätzlicher Phasenunterschied ($\Delta \psi_1$, $\Delta \psi_2$) bewirkt werden, und dass für die Fouriertransformation der in Spalten oder Reihen der Matrix vorhandenen Werte die bewirkten ersten und zweiten zusätzlichen Phasenunterschiede ($\Delta \psi_1$, $\Delta \psi_2$) beseitigt werden.

Wenn beim Füllen einer Matrix in den Resonanzsignalen von Zeile zu Zeile ein oben angegebener zusätzlicher Phasenunterschied angebracht ist, werden die Bildfehler nach einer dreidimensionalen Fouriertransformation zum Rand der äusseren Fläche (die Anzahl der Flächen und die Anzahl der Zeilen sind gerade Anzahlen) oder in den äusseren Zeilen an beiden Seiten der äusseren Fläche ausgestrichen. (Die Anzahl der Flächen ist gerade, die Anzahl der Zeilen ist ungerade).

Eine erfindungsgemässe Anordnung ist dadurch gekennzeichnet, dass sie weitere Mittel zum Erzeugen eines amplitudenmodulierten einheitlichen Magnetfelds enthält, und dass die Steuermittel vorprogrammierte Rechnermittel zum Erzeugen und Ergänzen von Steuersignalen zu den Mitteln zum Erzeugen eines amplitudenmodulierten einheitlichen Magnetfelds enthalten. Mit einer derartigen Anordnung sind (oben beschriebene) Verfahren durchführbar, die frei von den genannten Artefakten sind, wie bereits erläutert wurde.

Ausführungsbeispiele der Erfindung werden nachstehend an Hand der Zeichnung näher erläutert. Es zeigen

Fig. 1 schematisch eine Einrichtung eines Spulensystems einer Anordnung zur Durchführung eines erfindungsgemässen Verfahrens,

Fig. 2 ein Blockschaltbild einer Anordnung zur Durchführung des erfindungsgemässen Verfahrens,

Fig. 3 ein einfaches Ausführungsbeispiel eines Verfahrens nach dem Stand der Technik,

Fig. 4 ein Ausführungsbeispiel eines erfindungsgemässen Verfahrens,

Fig. 5 ein weiteres Ausführungsbeispiel eines erfindungsgemässen Verfahrens,

Fig. 6 einen Teil einer Anordnung nach der Erfindung,

Fig. 7 ein Ausführungsbeispiel eines Teils der Anordnung nach Fig. 2, und

Fig. 8 ein weiteres Ausführungsbeispiel eines Teiles der Anordnung nach Fig. 2.

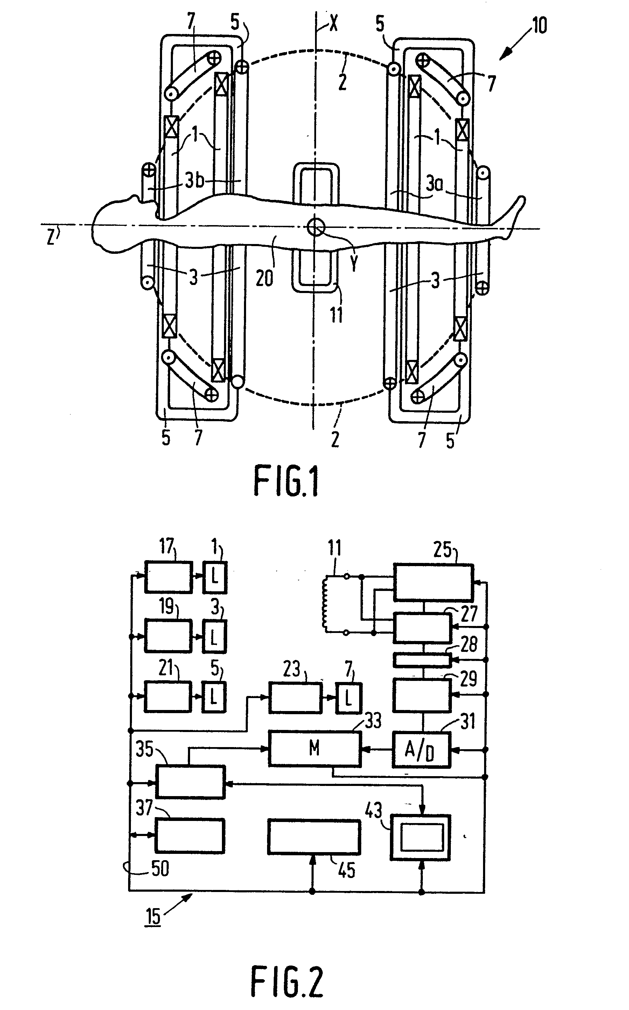

In Fig. 1 ist ein Spulensystem 10 dargestellt, das ein Teil einer Anordnung 15 (Fig. 2) ist, die zur Bestimmung einer Kernmagnetisierungsverteilung in einem Teil eines Körpers 20 benutzt wird. Der Teil hat beispielsweise eine Dicke $\Delta z$ und liegt in der x-y-Ebene des dargestellten x-y-z-Koordinatensystems. Die y-Achse des Systems verläuft dabei senkrecht zur Zeichenebene nach oben. Mit dem Spulensystem 10 wird ein einheitliches statisches Magnetfeld Bo mit einer Feldrichtung parallel zur z-Achse, werden drei Gradientenmagnetfelder $G_x$, $G_y$ und $G_z$ mit einer Feldrichtung parallel zur z-Achse und mit einer Gradientenrichtung parallel zur x-, y- bzw. z-Achse und wird ein hochfrequentes Magnetfeld erzeugt. Das Spulensystem 10 enthält dazu einige Hauptspulen zum Erzeugen des statischen einheitlichen Magnetfelds Bo mit einer Stärke zwischen 0,1 bis 2,5 Tesla. Die Hauptspulen 1 können beispielsweise auf der Oberfläche einer Kugel 2 angeordnet sein, deren Mitte im Ursprung O des wiedergegebenen karthesischen Koordinatensystems x, y, z liegt, wobei die Achsen der Hauptspulen 1 mit der z-Achse zusammenfallen.

Weiter enthält das Spulensystem 10 z,B, vier auf der gleichen Kugeloberfläche angeordnete Spule $3_a$, $3_b$, mit denen das Gradientenmagnetfeld $G_z$ erzeugt wird. Ein erster Satz 3a wird dazu in entgegengesetztem Sinn in bezug auf dem Durchfluss des zweiten Satzes 3b mit einem Strom erregt, was in der Figur mit ⊗ und ⊙ angegeben ist. Dabei bezeichnet ⊙ einen im Querschnitt der Spule 3 laufenden Strom und ⊗ einen aus dem Durchschnitt der Spule ankommenden Strom.

Das Spulensystem 10 enthält beispielsweise vier Rechteckspulen 5 (es sind nur zwei dargestellt) oder vier andere Spulen wie beispielsweise "Golay-Spulen" zum Erzeugen des Gradientenmagnetfelds $G_y$. Zum Erzeugen des Gradientenmagnetfelds $G_x$ dienen vier Spulen 7, die die gleiche Form wie die Spulen 5 besitzen und über einen Winkel von 90° um die Z-Achse in bezug auf die Spule 5 verdreht sind. Mit Fig. 1 ist weiter noch eine Spule 11 dargestellt, mit der ein hochfrequentes elektromagnetisches Feld erzeugbar und detektierbar ist.

In Fig. 2 ist eine Anordnung 15 zur Durchführung eines erfindungsgemässen Verfahrens dargestellt. Die Anordnung 15 enthält Spulen 1, 3, 5, 7 und 11, die anhand der Fig. 1 bereits erörtert wurden, Stromgeneratoren 17, 19, 21 bzw. 23 zum Erregen der Spulen 1, 3, 5 bzw. 7 und einen hochfrequenten Signalgenerator 25 zum Erregen der Spule 11. Die Anordnung 15 enthält weiter einen Hochfrequenzsignaldetektor 27, einen Demodulator 28, eine Abtastschaltung 29 Verarbeitungsmittel wie z.B. einen Analog/Digital-Wandler 31, einen Speicher 33 und eine Rechenschaltung 35 zur Durchführung von Fouriertransformationen, eine Steuereinheit 37 zum Steuern der Abtastzeitpunkte und weiter eine Wiedergabeanordnung 43 und die zentralen Steuermittel 45, deren Funktionen und gegenseitige Verhältnisse weiter unten erläutert werden.

Mit der beschriebenen Anordnung 15 wird ein Verfahren zum Bestimmen der Kernmagnetisierungsverteilung in einem Körper 20 durchgeführt, wie unten beschrieben wird. Das Verfahren umfasst ein vielfaches Wiederholen eines Messzyklus, der an sich wieder in mehrere Schritte eingeteilt werden kann. Bei einem Messzyklus wird ein Teil der im Körper vorhandenen Kernspinresonanz angeregt. Die resonante Anregung der Kernspins erfolgt durch das Einschalten des Stromgenerators 17 von der zentralen Steuereinheit 45 aus, wodurch die Spule erregt wurd und während der nachfolgenden Messzyklen erregt bleibt, wodurch ein statisches und einheitliches Magnetfeld Bo erzeugt wird. Weiter wird der Hochfrequenzgenerator 25 kurze Zeit eingeschaltet, so dass die Spule 11 ein hochfrequentes elektromagnetisches Feld (HF-Feld) erzeugt. Durch die angelegten Magnetfelder können die Kernspins im Körper 20 angeregt werden, wobei die angeregte Kernmagnetisierung einen bestimmten Winkel beispielsweise $90^{\circ}$ ($90^{\circ}$-HF-Impuls) mit dem einheitlichen Magnetfeld Bo bildet. An welcher Stelle und welche Kernspins angeregt werden, ist u.a. von der Stärke des Feldes Bo, von einem ggf. anzulegenden Gradientenmagnetfeld und von der Winkelfrequenz $\omega_o$ des hochfrequenten elektromagne-tischen Feldes abhängig, da die Gleichung $\omega_o = \gamma \cdot Bo$ (1) erfüllt werden muss, worin $\gamma$ das gyromagnetische Verhält-nis ist (für freie Protonen, beispielsweise $H_2O$-Protonen ist es $\gamma/2.\tilde{\pi} = 42{,}576$ MHz/T). Nach einer Anregungszeit wird der Hochfrequenzgenerator 25 von den zentralen Steuermitteln 45 abgeschaltet. Das resonante Anregen erfolgt jeweils am Anfang jedes Messzyklus. Für manche Ausführungsbeispiele werden während des Messzyklus auch HF-Impulse im Körper induziert. Diese HF-Impulse sind z.B. $180^{\circ}$-HF-Impulse oder eine aus $180^{\circ}$-HF-Impulsen zusammengesetzte Folge, die periodisch im Körper induziert werden. In diesem letzten Beispiel wird von "Mehrfachspinecho" gesprochen. Spinechotechniken sind u.a. in der Veröffentlichung von I.L. Pykett "NMR in Medicin" in Scientific American des Montats Mei 1982 beschrieben.

In einem folgenden Schritt werden brauchbare Abtastsignale gesammelt. Dabei können die Gradientenfelder verwendet werden, die die Generatoren 19 bzw. 21, 23 unter der Steuerung der zentralen Steuermittel 45 erzeugen. Die
Detektierung des Resonanzsignals (Kerninduktionssignal
genannt) erfolgt durch das Einschalten des Hochfrequenzdetektors 27, des Demodulators 22, der Abtastschaltung 29,
des Analog/Digital-Wandlers 31 und der Steuereinheit 37,
Dieses Kerninduktionssignal ist dadurch entstanden, dass
infolge des HF-Anregungsimpulses die Kernmagnetisierungen
angefangen haben, um die Feldrichtung des magnetischen
Feldes $\bar{B}o$ zu präzedieren. Diese Kernmagnetisierung induziert nunmehr in der Detektorspule eine Induktionsspannung,
deren Amplitude ein Mass für die Kernmagnetisierung ist.

Die aus der Abtastschaltung 29 herrührenden analogen abgetasteten Kerninduktionssignale werden in die
digitale Form (Wandler 31) umgewandelt und so in einen
Speicher 33 geschrieben. Nach der Probennahme eines letzten
Abtastsignals zu einem Zeitpunkt $t_e$ stoppen die zentralen
Steuermittel 45 die Generatoren 19, 21 und 23, die Abtastschaltung 29, die Steuereinheit 37 und den Analog/Digital-
Wandler 31.

Das abgetastete Kerninduktionssignal ist und bleibt
im Speicher 33 gespeichert. Danach wird ein folgender Messzyklus durchgeführt, bei dem ein dabei erzeugtes Kerninduktionssignal erzeugt, abgetastet und in den Speicher 33
eingeschrieben wird. Sind genügend Kerninduktionssignale
gemessen (die Anzahl der zu messenden Kerninduktionssignale
ist beispielsweise von der gewünschten zu erreichenden
Auflösung abhängig), ist über eine zweidimensionale oder
dreidimensionale Fouriertransformation (dies ist von der
Verwendung der Gradientenmagnetfelder abhängig, bei denen
die Kerninduktionssignale erzeugt bzw. abgetastet werden,
ein zwei- oder dreidimensionales Bild einer Kernmagnetisierung herzustellen.

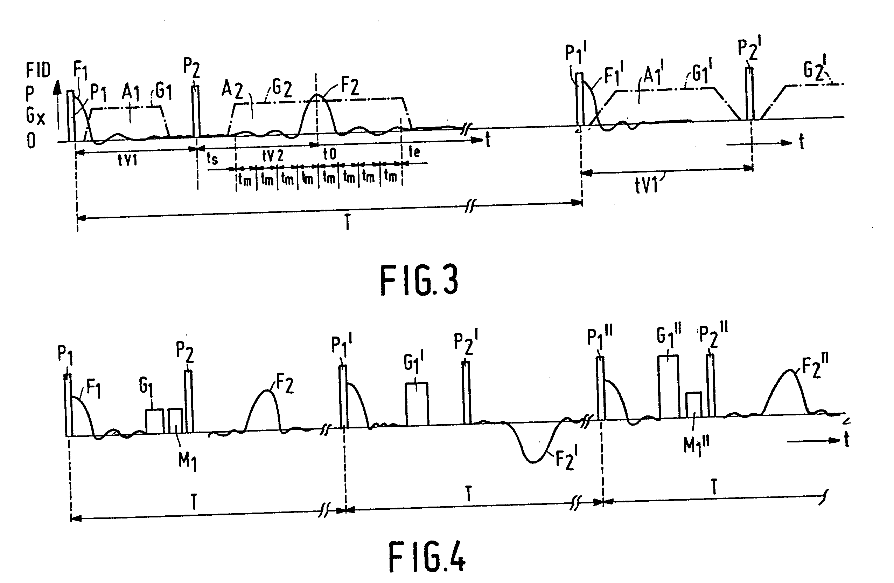

In Fig. 3 ist ein Beispiel eines Messzyklus nach
dem Stand der Technik dargestellt, der an Hand der Anordnung
15 in Fig. 2 näher erläutert wird. Mit der Hochfrequenzspule 11 wird nach dem Einschalten der Hauptspulen 1, die
ein statisches, homogenes Magnetfeld Bo erzeugen, ein
$90^o$-Impuls $P_1$ erzeugt. Das danach auftretende Resonanz-

signal $F_1$ lässt man bei Anwendung der Spinechotechnik abklingen und nach einer Zeit $t_{v1}$ wird mit der Hochfrequenzspule 11 ein $180^o$-Impuls $P_2$ erzeugt. Für einen Teil der
Zeit $t_{v1}$ wird ein mit einer Kurve $G_1$ bezeichnetes Gradientenfeld $G_x$ aus weiter unten zu beschreibenden Gründen erzeugt. Nach einer Zeitdauer $t_{v2}$, die genau so gross ist
wie $t_{v1}$, wird ein mit dem $180^o$-Impuls $P_2$ erzeugtes Echoresonanzsignal $F_2$ einen Spitzenwert erreichen. Die Anwendung
der sog. Spinechotechnik ($180^o$-Impuls $P_2$) verhindert das
Auftreten von Phasenfehlern in den von Kernspins erzeugten
Resonanzsignalen, und diese Phasenfehler treten durch
Inhomogenitäten im statischen Magnetfeld Bo auf. Das Echoresonanzsignal wird jeweils nach einem Abtastintervall $t_m$
abgetastet, wobei ein mit einer Kurve $G_2$ bezeichnetes Gradientenfeld $G_x$ vorhanden ist.

Bekanntlich ist der Phasenwinkel einer Magnetisierung an einem Punkt x in einem Gradientenmagnetfeld $G_x$
durch ${}^t\!\int \gamma \cdot G_x(\tau) \cdot x \cdot d\tau$ bestimmt. Dabei kann eine
Bildfrequenz $k_x$ definiert werden: $k_x = \int \gamma^t G_x(\tau) \cdot d\tau$.
Es wird also nach jeder Abtastzeit $t_m$ immer eine zu einer
anderen Bildfrequenz $k_x$ gehörende Signalprobe bestimmt.
Die aufeinanderfolgenden Bildfrequenzen zeigen einen Bildfrequenzunterschied $\Delta k_x = \gamma \cdot \int_{tm} G_x \cdot (\tau) \cdot d\tau$. Es
ist jetzt klar, dass, wenn der oben beschriebene Messzyklus
wiederholt wird, bei dem vor dem Abtasten einige Zeit ein
Gradientfeld $G_y$ angelegt ist, Signalproben erhalten werden,
die zu Bildfrequenzpaaren ($k_x$, $k_y$) gehören. Wenn kein
Gradientenmagnetfeld $G_y$ vorhanden ist, werden Signalproben
erhalten, die zu den Bildfrequenzen ($k_x$, o) gehören. Es
lässt sich nachweisen, dass, wenn eine Gruppe von Signalproben gesammelt wird, die zu einer Matrix von Bildfrequenzpaaren ($k_x$, $k_y$) gehört, wobei die Bildfrequenzen von
$-k_x$ bis $+k_x$ und von $-k_y$ bis $+k_y$ gehen, aus dieser Gruppe
von Signalproben über eine zweidimensionale Fouriertransformation eine Magnetisierungsverteilung in einer x-y-Ebene
bestimmbar ist. Nach einer Zeit T des mit dem Impuls $P_1$
gestarteten Messzyklus wird ein folgender Messzyklus mit
einem gleichen Messimpuls $P_1$ gestartet, um eine neue Reihe von Signalproben zu nehmen, die zu Bildfrequenzpaaren $(k_x, k_y)$ gehören, wobei $k_y$ konstante und zuvor dadurch festgelegt ist, dass im Zeitraum $t_{v1}$ zwischen den Impulsen $P_1$ und $P_2$ ausser einem Gradientenfeld $G_1$ ein (nicht dargestelltes) Gradientenfeld $G_y$ angelegt ist. Die zwischen dem Beginn von zwei Messzyklen ablaufende Zeit T beträgt bei den Verfahren nach dem Stand der Technik 0,5 bis 1 Sekunde. Wenn diese Zeit weiter gekürzt wird, geht dies auf Kosten des Kernspinsignals des folgenden Messzyklus, da ein wesentlicher Teil des angeregten Kernspins eine in bezug auf diese kürzere Zeit eine verhältnismässig längere Relaxationszeit hat. Nur jener Teil der Kernspins, die tatsächlich in Richtung des Hauptfeldes Bo rückrelaxiert sind, liefern dann einen Beitrag zum Spinechosignal.

In Fig. 4 ist ein Messzyklus eines erfindungsgemässen Verfahrens dargestellt, Dieser Messzyklus ist dem Messzyklus nach Fig. 3 nahezu gleich. Der Deutlichkeit halber sind in Fig. 4 keine Gradientenfelder in der Messzeit und nur die relevanten Signale, wie z.B. die Anregungsimpulse $P_1$, $P_1'$ die $180^o$-Impulse $P_2$, $P_2'$ und die Resonanzsignale $F_1$, $F_1'$, $F_2$, $F_2'$ dargestellt. Weiter sind in den aufeinanderfolgenden Messzyklen (je mit einer Dauer T) die verschiedenen (Vorbereitungs-)Gradientenmagnetfelder $G_1$, $G_1'$, $G_1''$ und die Modulation $M_1$, $M_1'$ des statischen einheitlichen Magnetfelds dargestellt. Die aufeinanderfolgenden Messzyklen unterscheiden sich voneinander in folgenden Hinsichten: In jedem zweiten Messzyklus werden die angeregten Kernspins mit der Modulation $M_1$, $M_1'$ des statischen einheitlichen Magnetfelds in entgegengesetzte Phase gebracht und die aufeinanderfolgenden Gradientenfelder $G_1$, $G_1'$, $G_1''$ ... werden schrittweise in ihrer Stärke grösser. Durch die schrittweise Vergrösserung des Gradientenfeldes $G_1$ werden aus dem auftretenden Spinechosignal $F_2$, $F_2'$, $F_2''$ in jedem Messzyklus T nebeneinander liegende Reihen von Signalproben in der $(k_x, k_y)$ Bildfrequenzmatrix erhalten.

Durch die Einführung der angeregten Kernspins in eine entgegengesetzte Phase werden die abzutastenden Spinechosignale $F_1$, $F_1'$, $F_1''$ ebenfalls gegenphasig. Durch die Invertierung der Werte jeder zweiten Zeile ist der Einfluss der Gegenphasierung der Kernspins auf das Spinechosignal wieder ausgleichbar. Da die Art der Modulation $M_1$, $M_1''$ keinen Einfluss auf kohärente Störsignale hat, hat durch die Invertierung der Werte in jeder zweiten Zeile der Beitrag dieser Störsignale von Spalte zu Spalte in der Bildfrequenzmatrix ein wechselndes Vorzeichen. Der unerwünschte Beitrag beispielsweise des Verlagerungssignals wird faktisch von einer Frequenz "O" nach einer vom Abtasttheorem bestimmten möglichst hohen Frequenz in einer Spalte umgewandelt und wird also bei Fouriertransformation nach dem Rand (nach den Rändern) der transformierten Spalte gemäss der oben bereits angegebenen Punktstreuungsfunktion verschoben.

In obiger Beschreibung ist ein Verfahren angegeben, bei dem die unerwünschten Signalbeiträge zeilenweise in der gemessenen Bildfrequenzmatrix phasenmässig wechseln, wodurch die Artefakte sich in der Bildmatrix zum Rand der Matrix verschieben. Jetzt ist es jedoch nicht in allen Situationen notwendig, phasenmässig wechselnde Signalbeiträge zu erzeugen. Der zusätzliche Phasenunterschied zwischen den Resonanzsignalen, die zu den aufeinanderfolgenden Zeilen (oder Flächen) in der Bildfrequenzmatrix gehören, hat im optimalen Fall den Wert $\Delta \psi = (m-1) . \pi /m$, wobei m die Anzahl der Zeilen (oder Flächen) ist. Zur Erläuterung wird eine eindimensionale Situation betrachtet, bei der ein Signal äquidistant in der Zeit bei einem Abtastintervall $t_j$ abgetastet wird, Die Bandbreite Fw des abgetasteten Signals beträgt nach der Fouriertransformation: $Fw = 1/t_j$, und die Auflösung (Zwischenräume der Frequenzen) beträgt $\Delta f = 1/(NS \times t_j)$, wobei NS die Anzahl der gewonnenen Signalproben ist, Die grösste, im Spektrum auftretende Frequenz $F_{max}$ ist bei einer geraden Anzahl von Abtastungen $F_{max} = NS . \Delta f/2$ und bei einer ungeraden Anzahl von Abtastungen $F_{max} = (NS-1) . \Delta f/2$. Jetzt beträgt der Phasenunterschied zwischen zwei aufeinanderfolgenden Abtastungen (für diese höchste Frequenz):

$\Delta \psi = 2 . \pi . F_{max}/t_f$. Nach der Substitution von $1/t_j = \Delta f.NS$

und der Gleichung für $F_{max}$ folgt, dass der Phasenunterschied $\Delta \psi = \pi$ , wenn NS geradzahlig ist und

$\Delta \psi$ = (NS-1). $\pi$/NS, wenn NS ungeradzahlig ist.

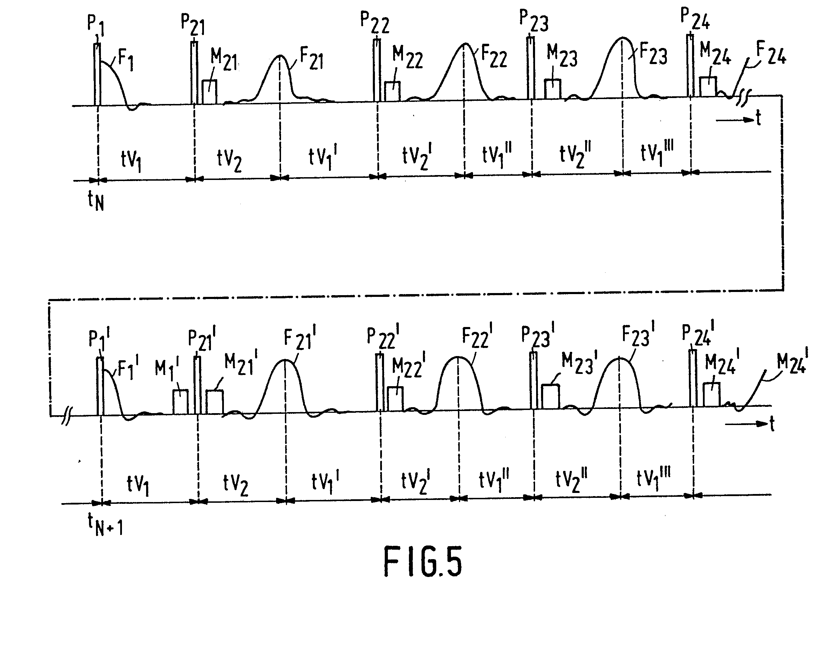

In Fig. 5 ist ein Ausführungsbeispiel eines weiteren erfindungsgemässen Verfahrens dargestellt, bei dem die Erfindung in der sog. Mehrfachechotechnik angewendet wird. Nach einem $90^{\circ}$-Anregungsimpuls $P_1$ wird mit Zwischenzeiten eine Anzahl von Kernspinresonanzsignalen $F_2$, $F_{2_2}$, $F_{2_3}$ ... mit Hilfe von $180^{\circ}$ Echoimpulsen $P_{2_1}$, $P_{2_2}$, $P_{2_3}$ ... erzeugt. Die hochfrequenten elektromagnetischen Echoimpulse $P_{2_1}$, $P_{2_2}$ ... sind in der Praxis nicht ideal, was verursacht, dass die Resonanzsignale $F_{2_1}$, $F_{2_2}$ ... Beiträge von Kernspins enthalten, die mit einem perfekten $180^{\circ}$-Impuls diese Beiträge nicht liefern würden. Die Resonanzsignale werden abgetastet, wobei die Signalproben eines ersten, zweiten, dritten, vierten Resonanzsignals $F_{2_1}$, $F_{2_2}$, $F_{2_3}$ ... in eine erste, zweite, dritte, vierte Fläche einer Bildfrequenzmatrix eingeschrieben werden.

Nach den $180^{\circ}$-Echoimpulsen $P_{21}$ bis $P_{24}$ wird durch Amplitudenmodulation des statischen, einheitlichen Magnetfeldes Bo, was in Fig. 5 mit den Impulsformen $M_{21}$, $M_{22}$, $M_{23}$ und $M_{24}$ angegeben ist, den Kernspins eine zusätzliche Phasendrehung gegeben. Das Ergebnis davon ist, dass die Resonanzsignale, die in die Matrix eingeschrieben werden, ein von Fläche zu Fläche wechselndes Vorzeichen haben (beispielsweise Fläche 1: positiv; Fläche 2: negativ; Fläche 3: positiv; Fläche 4: negativ usw.). Wenn die Anzahl m der Flächen ungeradzahlig wäre, würde die zusätzliche Gesamtphasendrehung $\Delta \psi_{tot}$ in der Fläche 4

$\Delta \psi_{tot}$ = 4. $\Delta \psi$ mod($2\pi$) ($\Delta \psi$ = (m-1). $2\pi$/m) betragen.

Am Ende eines Messzyklus, der zum Zeitpunkt $t_N$ anfing, startet ein folgender Messzyklus zum Zeitpunkt $t_{N+1}$, der nahezu gleich dem des vorangehenden ist, mit Ausnahme eines Vorbereitungsgradienten (der Deutlichkeit halber ausgelassen) und der Modulation $M_1$ des statischen einheitlichen Magnetfeldes, die die angelegten Kernspins in bezug auf die Kernspins im vorangehenden Messzyklus in Gegenphase bringen. Die so erzeugten Resonanzsignale $F_{2_1}'$, $F_{2_2}'$, $F_{2_3}'$ ... werden genau so wie im vorangehenden Messzyklus abgetastet und die Signalproben werden auf gleiche Weise in die Flächen der Matrix eingeschrieben. Durch schrittweise Vergrösserung des Vorbereitungsgradienten in den aufeinanderfolgenden Messzyklen können in jeder Bildfrequenzfläche die nebeneinander liegenden Zeilen nacheinander gefüllt werden. Die von Messzyklus zu Messzyklus von der zusätzlichen Modulation $M_1'$ in Gegenphase gebrachten Resonanzsignale schreiben die von den nicht idealen $180^o$-Umkehrimpulsen erzeugten kohärenten Störsignale in eine Fläche von Zeile zu Zeile immer mit dem gleichen Vorzeichen ein. Weiter werden die erzeugten Resonanzsignale von den Modulationen $M_{21}$, $M_{22}$ ... und $M_{21}'$, $M_{22}'$ ... in Gegenphase gebracht, so dass sie in die Flächen der dreidimensionalen Matrix mit einem von Fläche zu Fläche wechselndes Vorzeichen eingeschrieben werden, während die in den Resonanzsignalen vorhandenen Störsignale nicht von der Modulation des einheitlichen Magnetfelds beeinflusst sind und gleichsam stets mit dem gleichen Vorzeichen eingeschrieben sind. Werden jetzt in einer Fläche der geradzahligen Zeilen die Vorzeichen und in der (den zwei) Nachbarfläche(n) die Signalproben der ungeradzahligen Zeilen gewechselt, haben die Störsignale von Fläche zu Fläche und von Zeile zu Zeile in einer Fläche ein wechselndes Vorzeichen (bei einer geraden Anzahl von Zeilen und einer geraden Anzahl von Flächen) und also faktisch eine höchste Signalfrequenz. Daher verursachen die Störsignale nach der Fouriertransformation der Bildfrequenzmatrix in einer Bildmatrix nur an einem Rand (oder an zwei Rändern, wie oben bereits beschrieben) Bildabweichungen.

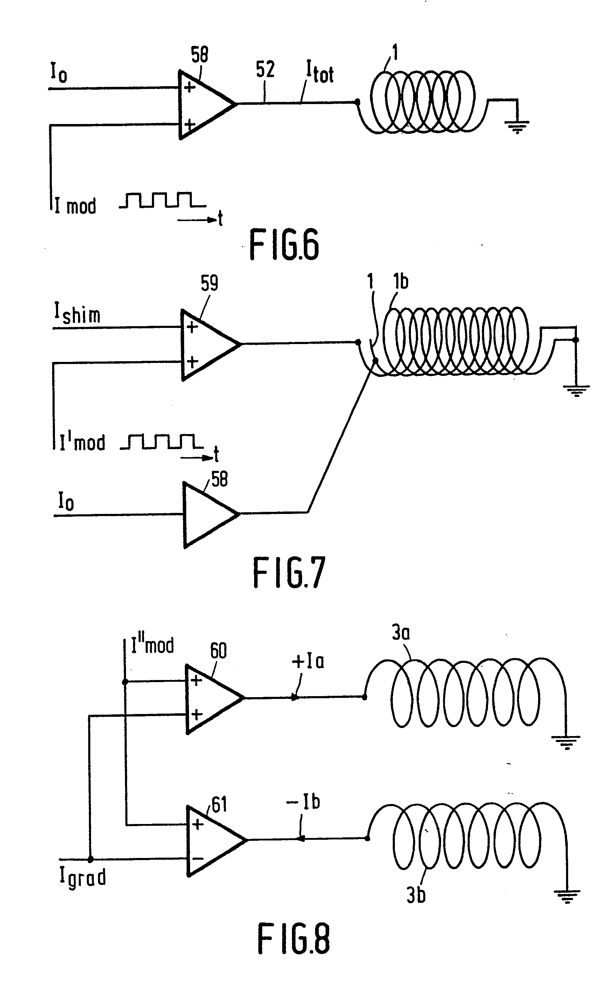

Das Anbringen eines zusätzlichen Phasenunterschieds $\Delta \varphi$ zwischen zwei Resonanzsignalen kann auf verschiedene Weisen verwirklicht werden. Wie in Fig. 1 und 2 dargestellt und beschrieben, wird das statische einheitliche Magnetfeld Bo mit einem Spulensystem 1 erzeugt, das von einem Stromgenerator 17 gespeist wird. Wenn nun einem Ausgangsverstärker 58 des Stromgenerators 15 ausser dem Steuersignal
lo, mit dem das Magnerfeld Bo erzeugt wird, ein in der
Amplitude moduliertes Signal $I_{mod}$ zugeführt, wird die
Spule 1 (siehe Fig. 6) mit einem Strom $I_{tot} = I_o + I_{mod}$
gesteuert. Das erzeugte Gesamtfeld B ist eine Überlagerung
des statischen Feldes Bo und eines zeitlich modulierten
Feldes und ist also ein amplitudenmoduliertes einheitliches
Feld.

Eine weitere Möglichkeit zum Erzeugen eines amplitudenmodulierten Feldes ist die Verwendung von Abgleichspulen 1b (Trimmspulen), die dazu verwendet werden, dem stationären Feld eine sehr hohe Einheitlichkeit zu geben.
Der Deutlichkeit halber sind diese Abgleichspulen 1b nicht
in der Fig. 1 dargestellt, aber in der Praxis sind diese
Spulen 1b parallel zu den Spulen 1 angebracht und sie
haben die gleiche Form. In Fig. 7 sind der Verstärker 58
und die Spule 1 nach Fig. 6 ebenfalls dargestellt, die den
Strom $I_o$ empfangen bzw. das Magnetfeld Bo erzeugen. Von den
Abgleichspulen 1b ist nur eine dargestellt, die ein Stromgenerator 59 speist (die verschiedenen Abgleichspulen werden
zum Ermöglichen eines geeigneten Abgleichs getrennt gespeist). Dem Abgleichstrom $I_{shim}$ wird ein Modulationsstrom
$I_{mod}$ überlagert (die für die verschiedenen Abgleichspulen
verschieden sein kann), so dass dem Hauptmagnetfeld Bo ein
zeitlich moduliertes einheitliches Magnetfeld überlagert
wird.

In Fig. 8 ist eine weitere Möglichkeit zum Erzeugen eines amplitudenmodulierten einheitlichen Magnetfelds
gegeben, bei der Gradientenspulen verwendet werden. Im
hier gegebenen Beispiel werden die Z-Gradientenspulen 3a,
3b verwendet. Auch können die x-Gradientenspulen 5 oder die
y-Gradientenspulen 7 verwendet werden. Die Gradientenspulen
3a und 3b speist ein Stromgenerator 19 (siehe Fig. 2), wobei
diese Gradientenspulen dafür Ausgangsverstärker 60 und 61
enthalten, die ein Gradientenstromsignal $I_{grad}$ erhalten
und Ausgangsströme an ihren Ausgängen 62 und 63 erzeugen,
die wie in Fig. 8 mit Pfeilen (+I und -I) angegeben,

0205199

entgegengesetzt gerichtet sind. Das Gradientenstromsignal $I_{grad}$ wird beim Verstärker 61 dem Minus-Eingang und beim Verstärker 60 dem Plus-Eingang zugeführt. Jetzt wird zum Erzeugen eines amplitudenmodulierten einheitlichen Feldes ein Modulationsstromsignal $I_{mod}$" einem Plus-Eingang der beiden Verstärker 60 und 61 zugeführt. Der Strom durch die Spule 3a wird also vergrössert und der Strom durch die Spule 3b verringert. Es wird jetzt mit dem Gradientenspulensystem 3a, 3b (ausser einem Gradientenfeld) ein (schwaches) zeitlich moduliertes einheitliches Magnetfeld erzeugt, das zusammen mit dem von den Spulen 1 erzeugten Magnetfeld Bo ein amplitudenmoduliertes einheitliches Magnetfeld bildet.

PATENTANSPRÜCHE:

1.      Verfahren zur Bestimmung einer Kernmagnetisierungsverteilung in einem Teil eines Körpers, bei dem ein statisches einheitliches Magnetfeld erzeugt wird, in dem sich der Teil des Körpers befindet, und

a) ein hochfrequenter elektromagnetischer Impuls zum Erhalten einer Präzessionsbewegung der Magnetisierung von Kernen im Körper und dadurch ein Resonanzsignal erzeugt wird,

b) wonach in einer Vorbereitungszeit zumindest ein Gradientenmagnetfeld angelegt wird,

c) wonach in einer Messzeit eine erste Anzahl von Signalproben des Resonanzsignals genommen wird,

d) wonach jeweils nach einer Wartezeit ein Messzyklus mit den Schritten a), b) und c), wobei das Integral der Stärke zumindest eines Gradientenfeldes über die Vorbereitungszeit jedesmal einen verschiedenen Wert, zum Erhalten einer Gruppe von Signalproben in einer aus (m) Zeilen und (n) Spalten bestehenden Matrix eine zweite Anzahl Male wiederholt wird, wobei je Messzyklus zumindest eine Zeile gefüllt und aus der nach der Fouriertransformation derselben ein Bild der Verteilung der induzierten Kernmagnetisierung bestimmt wird, dadurch gekennzeichnet, dass in verschiedenen Messzyklen eine Amplitudenmodulation des statischen, einheitlichen Magnetfeldes derart erfolgt, dass zwischen den Resonanzsignalen die zu den verschiedenen hinsichtlich des Wertes des Integrals der Stärke des Gradientenfeldes über die Vorbereitungszeit aufeinanderfolgender Zeilen in der Matrix gehören, stets ein gleicher zusätzlicher Phasenunterschied ($\Delta \psi$) ausgelöst wird und dass für Fouriertransformation von in Spalten der Matrix vorhandenen Werten die bewirkten Zusatzphasenunterschiede ($\Delta \psi$) beseitigt werden.

2.      Verfahren nach Anspruch 1, dadurch gekennzeichnet, dass der zusätzliche Phasenunterschied ($\Delta \psi$) gleich
$\pi$ . (m-1)/m rad/sec ist, wobei m die Anzahl von Zeilen
der Matrix und ungeradzahlig ist.

3.       Verfahren nach Anspruch 1, <u>dadurch gekennzeichnet</u>,
dass die Anzahl der Zeilen (m) der Matrix geradzahlig ist,
dass der Phasenunterschied ($\Delta \psi$) gleich $\pi$ rad/sec ist, und
dass für Fouriertransformation der in Spalten der Matrix
vorhandenen Werte entweder in den geradzahligen Zeilen oder
in den ungeradzahligen Zeilen vorhandene Werte invertiert
werden, um den zusätzlichen Phasenunterschied zu beseitigen.

4.       Verfahren nach Anspruch 3, bei dem der Wert des
Integrals der Stärke des Gradientenfeldes über die Vorbereitungszeit für jeden auffolgenden Messzyklus mit einem
gleichen Wert erhöht wird, <u>dadurch gekennzeichnet</u>, dass die
angeregten Kernspins in aufeinanderfolgenden Messzyklen
eine je Zyklus das Vorzeichen wechselnde Phasendrehung
($\Delta \psi$) erfahren.

5.       Verfahren nach Anspruch 3 und 4, <u>dadurch gekenn-
zeichnet</u>, dass die angeregten Kernspins eine Phasendrehung
($\Delta \psi$) von $\pi/2$ rad/sec oder nahezu $\pi/2$ rad/sec erfahren.

6.       Verfahren nach Anspruch 1, 2 oder 3, bei dem der
Wert des Integrals der Stärke des Gradientenfeldes über
die Vorbereitungszeit für jeden folgenden Messzyklus mit
dem gleichen Wert erhöht wird, <u>dadurch gekennzeichnet</u>,
dass die angeregten Kernspins entweder nur in jedem zweiten
Messzyklus eine Phasendrehung von $\pi$ rad/sec oder nahezu
$\pi$ rad/sec erfahren.

7.       Verfahren zur Bestimmung einer Kernmagnetisierungsverteilung in einem dreidimensionalen Teil eines Körpers,
bei dem ein statisches, einheitliches Magnetfeld erzeugt
wird, in dem sich der Körper befindet und
a) ein hochfrequenter elektromagnetischer Impuls zum Erhalten einer Präzessionsbewegung der Magnetisierung von
Kernen im Körper erzeugt wird, wobei ein Resonanzsignal
erzeugt wird,
b) wonach in einer Vorbereitungszeit zumindest ein erstes
und ein zweites Vorbereitungsgradientenmagnetfeld angelegt
wird, deren Feldrichtungen senkrecht zueinander verlaufen,

c) wonach in einer Messzeit eine Anzahl von Abtastsignalen vom Resonanzsignal genommen wird,

d) wonach jeweils nach einer Wartezeit ein Messzyklus mit den Schritten a), b) und c) einige Male wiederholt wird, wobei ein erstes Integral der Stärke des ersten Gradientenfeldes über die Vorbereitungszeit eine erste Anzahl verschiedener Werte hat und ein zweites Integral der Stärke des zweiten Gradientenfeldes über die Vorbereitungszeit eine zweite Anzahl verschiedener Werte zum Erhalten einer Gruppe von Signalproben in einer aus Reihen, Zeilen und Spalten bestehenden dreidimensionalen Matrix hat, von der eine Fläche Zeilen und Spalten enthält, wobei je Messzyklus zumindest eine Zeile einer Fläche gefüllt wird und aus dieser Matrix nach der Fouriertransformation derselben ein Bild der Verteilung der induzierten Kernmagnetisierung in einem dreidimensionalen Teil eines Körpers bestimmt wird, **dadurch gekennzeichnet**, dass in verschiedenen Messzyklen eine Amplitudenmodulation des statischen, einheitlichen Magnetfeldes derart erfolgt, dass zwischen den Resonanzsignalen, die zu den verschiedenen, hinsichtlich des Wertes des Integrals der Stärke des ersten Gradientenfeldes über die Vorbereitungszeit aufeinanderfolgenden Flächen in der Matrix gehören und zwischen den Resonanzsignalen, die zu den verschiedenen, hinsichtlich des Wertes des Integrals der Stärke des zweiten Gradientenfeldes über die Vorbereitungszeit aufeinanderfolgenden Zeilen in einer Fläche der Matrix gehören, stets ein erster und ein zweiter zusätzlicher Phasenunterschied ($\Delta\psi_1$, $\Delta\psi_2$) verursacht werden, und dass für Fouriertransformation von in Spalten oder Reihen der Matrix vorhandenen Werten die bewirkten ersten und zweiten zusätzlichen Phasenunterschiede ($\Delta\psi_1$, $\Delta\psi_2$) beseitigt werden.

8.      Verfahren nach Anspruch 7, **dadurch gekennzeichnet**, dass der erste zusätzliche Phasenunterschied ($\Delta\psi_1$) gleich $\pi(1-1)/1$ rad/sec ist, wobei 1 die Anzahl der Flächen der Matrix und ungeradzahlig ist.

9.      Verfahren nach Anspruch 7 oder 8, **dadurch gekennzeichnet**, dass der zweite zusätzliche Phasenunterschied

$(\Delta\psi_2)$ gleich $\widetilde{\pi}$ (m-1)/m rad/sec ist, wobei m die Anzahl der Zeilen in einer Fläche der Matrix und ungeradzahlig ist.

10.       Verfahren nach Anspruch 7, <u>dadurch</u> <u>gekennzeichnet</u>, dass die Anzahl der Flächen (1) der Matrix geradzahlig ist, dass der erste Phasenunterschied $(\Delta\psi_1)$ gleich $\widetilde{\pi}$ rad/sec ist, und dass für Fouriertransformation der in einer Reihe der Matrix vorhandenen Werte entweder in den geradzahligen Flächen oder in den ungeradzahligen Flächen vorhandene Werte dieser Reihe invertiert werden, um den ersten zusätzlichen Phasenunterschied $(\Delta\psi_1)$ zu beseitigen.

11.       Verfahren nach Anspruch 7 oder 10, <u>dadurch gekenn-</u> <u>zeichnet</u>, dass die Anzahl der Zeilen (m) in einer Fläche geradzahlig ist, dass der zweite zusätzliche Phasenunterschied $(\Delta\psi_2)$ gleich $\widetilde{\pi}$ rad/sec ist, und dass für Fouriertransformation der in Spalten einer Fläche vorhandenen Werte entweder in der geradzahligen Zeilen oder in den ungeradzahligen Zeilen vorhandene Werte dieser Spalte invertiert werden, um den zweiten zusätzlichen Phasenunterschied $(\Delta\psi_2)$ zu beseitigen.

12.       Verfahren nach Anspruch 7, 10 oder 11, bei dem das erste Integral stets nach einer gleichen Änderung des Wertes in einer Anzahl von Messzyklen (m) konstant bleibt, wobei das zweite Integral stets einen verschiedenen, von zwei äussersten Werten begrenzten Wert annimmt und dabei schrittweise vom einen äussersten Wert in den anderen über-geht, <u>dadurch gekennzeichnet</u>, dass die Anzahl der Flächen (1) und die Anzahl der Zeilen (m) geradzahlig sind, wobei zwischen den Resonanzsignalen, die zu den geradzahligen Zeilen in den geradzahligen Flächen und zu den ungeradzahligen Zeilen in den ungeradzahligen Flächen gehören, und den Resonanzsignalen, die zu den ungeradzahligen Zeilen in den geradzahligen Flächen und zu den geradzahligen Zeilen in den ungeradzahligen Flächen gehören, die Gesamtheit der zusätzlichen Phasenunterschiede $\widetilde{\pi}$ rad/sec ist, wobei durch Invertierung der Werte entweder in den geradzahligen Zeilen der geradzahligen Flächen und in den ungeradzahligen Zeilen der ungeradzahligen Flächen oder in den ungeradzahligen Zeilen der geradzahligen Flächen und in den den geradzahligen Zeilen der ungeradzahligen Flächen die zusätzlichen Phasenunterschiede beseitigt werden.

13.      Verfahren nach Anspruch 5 oder 12, dadurch gekennzeichnet, dass die Stärke des statischen, einheitlichen Magnetfeldes in den aufeinanderfolgenden Messzyklen für einen Teil der Vorbereitungszeit aufeinanderfolgend derart vergrössert und verringert wird, dass das Integral der Erhöhung bzw. der Verringerung über die Vorbereitungszeit $+ \pi/2$ rad/sec bzw. $- \pi/2$ rad/sec beträgt.

14.      Anordnung zur Bestimmung der Kernmagnetisierungsverteilung in einem Teil eines Körpers, wobei diese Anordnung folgende Elemente enthält:

a) Mittel zum Erzeugen eines statischen einheitlichen Magnetfeldes,

b) Mittel zum Erzeugen einer hochfrequenten elektromagnetischen Strahlung,

c) Mittel zum Erzeugen zumindest eines Gradientenmagnetfeldes,

c) Abtastmittel zum Abtasten eines mit den unter a) und b) genannten Mitteln erzeugten Resonanzsignals nach der Konditionierung mit zumindest einem mit den unter c) genannten Mitteln erzeugten Gradientenmagnetfeld,

e) Verarbeitungsmittel zum Verarbeiten des von den Abtastmitteln gelieferten Signals,

f) Steuermittel zum Steuern zumindest der unter b) bis e) genannten Mittel zum Erzeugen, Konditionieren, Abtasten und Verarbeiten einer Anzahl von Resonanzsignalen, wobei jedes Resonanzsignal stets in einer Vorbereitungszeit konditioniert wird, wobei die Steuermittel den unter c) genannten Mitteln Steuersignale zum Einstellen der Stärke und/oder der Zeitdauer zumindest eines Gradientenmagnetfeldes zuführen, wobei jeweils nach jeder Wartezeit das Integral der Stärke über die Dauer zumindest eines Gradientenmagnetfeldes verschieden ist, dadurch gekennzeichnet, dass die Anordnung weitere Mittel zum Erzeugen eines amplitudenmodulierten einheitlichen Magnetfeldes enthält und dass die Steuermittel vorprogrammierte Rechnermittel zum Erzeugen eines amplitudenmodulierten einheitlichen Magnetfeldes enthalten.

15.      Anordnung nach Anspruch 14, bei der die Mittel zum Erzeugen eines statischen einheitlichen Magnetfeldes ein Spulensystem enthält, dadurch gekennzeichnet, dass mit den weiteren Mitteln die Stromstärke durch das Spulensystem während einer Vorbereitungszeit moduliert.

16.      Anordnung nach Anspruch 14, dadurch gekennzeichnet, dass die weiteren Mittel ein weiteres Spulensystem enthalten.

17.      Anordnung nach Anspruch 14, bei der die Mittel zum Erzeugen eines Gradientenmagnetfeldes ein Gradientenspulensystem mit zumindest einem Spulenpaar enthält, dadurch gekennzeichnet, dass die weiteren Mittel derart an das Gradientenspulensystem angeschlossen sind, dass die weiteren Mittel einen Strom durch eine Spule des Spulenpaares in bezug auf den Strom durch die andere Spule des Spulenpaares in entgegengesetztem Sinne ändert.

FIG.1

FIG.2

0205199

FIG.3

FIG.4

FIG.5

3-Ⅳ-PHN 11386

0205199

FIG.6

FIG.7

FIG.8

# 0205199

**Europäisches Patentamt**

## EUROPÄISCHER RECHERCHENBERICHT

EP 86 20 0856

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int Cl 4) |
|---|---|---|---|
| A | EP-A-0 130 479 (GENERAL ELECTRIC COMPANY) * Seite 3, Zeile 19 - Seite 4, Zeile 9; Seite 5, Zeile 2 - Seite 7, Zeile 34 * | 1,3,4, 7 | G 01 N 24/08 |
| A | GB-A-2 128 746 (UTSUNOMIYA UNIVERSITY) * Seite 1, Zeile 48 - Seite 2, Zeile 34; Seite 3, Zeilen 34-54 * | 1,7 | |
| A | GB-A-2 037 996 (EMI Ltd.) * Seite 1, Zeilen 42-63; Seite 3, Zeilen 19-54; Seite 5, Zeilen 14-102 * | 1,7,14 | |
| A | EP-A-0 121 312 (A.MACOVSKI) * Seite 3, Zeile 4 - Seite 7, Zeile 6. * | 1,7,14 | RECHERCHIERTE SACHGEBIETE (Int. Cl.4) |
| A | EP-A-0 127 850 (GENERAL ELECTRIC COMPANY) * Seite 4, Zeile 19 - Seite 5, Zeile 6; Seite 16, Zeilen 1-18. * | 1,7 | G 01 N 24/00 |
| A | EP-A-0 073 671 (TOKYO SHIBAURA DENKI K.K) * Seite 14, Zeile 16 - Seite 17, Zeile 17 * | 1,14 | |

--- -/-

Der vorliegende Recherchenbericht wurde für alle Patentansprüche erstellt.

| Recherchenort | Abschlußdatum der Recherche | Prüfer |
|---|---|---|
| DEN HAAG | 01-09-1986 | HORAK G.I. |

Europäisches
Patentamt

**EUROPÄISCHER RECHERCHENBERICHT**

| **EINSCHLÄGIGE DOKUMENTE** | | | Seite 2 |
|---|---|---|---|
| Kategorie | Kennzeichnung des Dokuments mit Angabe, soweit erforderlich, der maßgeblichen Teile | Betrifft Anspruch | KLASSIFIKATION DER ANMELDUNG (Int Cl 4) |
| A,P | EP-A-0 155 052  (N.V. PHILIPS GLOEILAMPENFABRIEKEN)<br>* Seite 1, Zeile 1 - Seite 11, Zeile 22; Seite 24, Zeile 1 - Seite 29, Zeile 25; Abbildungen 1-3 *<br><br>-----| 1-6,14 | |
| | | | RECHERCHIERTE SACHGEBIETE (Int Cl 4) |

Der vorliegende Recherchenbericht wurde für alle Patentansprüche erstellt.

| Recherchenort | Abschlußdatum der Recherche | Prüfer |
|---|---|---|
| DEN HAAG | 01-09-1986 | HORAK G.I. |